# EUROPÄISCHE PATENTSCHRIFT

(11) **EP 2 714 582 B1**
(45) Veröffentlichungstag und Bekanntmachung des Hinweises auf die Patenterteilung: **30.09.2015**
(21) Anmeldenummer: 12723196.7
(22) Anmeldetag: 24.05.2012
(51) Int. Cl.: B81C 1/00, G01L 9/00, H01L 21/764

(54) **VERFAHREN ZUR HERSTELLUNG EINES MOS-TRANSISTORS**
METHOD FOR PRODUCING AN MOS TRANSISTOR
PROCÉDÉ DE FABRICATION D'UN TRANSISTOR MOS

(30) Priorität: 03.06.2011 EP 11168645
(43) Veröffentlichungstag der Anmeldung: 09.04.2014
(73) Patentinhaber: ELMOS Semiconductor AG, 44227 Dortmund (DE)
(72) Erfinder: KLEINSCHMIDT, Frank, 44227 Dortmund (DE); TEN HAVE, Arnd, 44227 Dortmund (DE)
(74) Vertreter: Von Kreisler Selting Werner - Partnerschaft von Patentanwälten und Rechtsanwälten mbB
(86) Internationale Anmeldenummer: PCT/EP2012/059675
(87) Internationale Veröffentlichungsnummer: WO 2012/163783

(56) Entgegenhaltungen:
- US-A1- 2010 171 153
- JACHOWICZ R S ET AL: "FET pressure sensor and iterative method for modelling of the device", 1. April 2002 (2002-04-01), SENSORS AND ACTUATORS A, ELSEVIER SEQUOIA S.A., LAUSANNE, CH, PAGE(S) 369 - 378, XP004361624, ISSN: 0924-4247 Abbildung 1
- SVENSSON L ET AL: "Surface micromachining technology applied to the fabrication of a FET pressure sensor", JOURNAL OF MICROMECHANICS & MICROENGINEERING, INSTITUTE OF PHYSICS PUBLISHING, BRISTOL, GB, Bd. 6, Nr. 1, 1. März 1996 (1996-03-01), Seiten 80-83, XP020069032, ISSN: 0960-1317, DOI: 10.1088/0960-1317/6/1/018
- CHANG-HAN YUN ET AL: "Fabrication of Silicon and Oxide Membranes Over Cavities Using Ion-Cut Layer Transfer", JOURNAL OF MICROELECTROMECHANICAL SYSTEMS, IEEE SERVICE CENTER, US, Bd. 9, Nr. 4, 1. Dezember 2000 (2000-12-01), XP011034603, ISSN: 1057-7157

## Beschreibung

Die Erfindung betrifft ein Verfahren zur Herstellung eines MOS-Transistors mit einer einen vergrabenen Hohlraum aufweisenden Gate-Struktur. Insbesondere betrifft die Erfindung eine Halbleiterstruktur mit einem Hohlraum, der von einer Membran überdeckt ist. Eine derartige Halbleitervorrichtung lässt sich z.B. zur Herstellung eines Drucksensors z.B. in Form eines druckempfindlichen Transistors verwenden.

Mikroelektromechanische Strukturen (MEMS) als Drucksensoren (Absolut- oder Relativdrucksensoren) sind an sich bekannt. Sie weisen zumeist zwei miteinander verbondete, das heißt schmelzkontaktierte Halbleitersubstrate auf, wobei eines der beiden Halbleitersubstrate eine Oberflächenvertiefung aufweist, die nach dem Verbonden beider Halbleitersubstrate von dem anderen Halbleitersubtrat überdeckt ist. Eines der beiden, Halbleitersubstrate ist in seinem den Hohlraum verschließenden Bereich vorzugsweise relativ dünn ausgebildet und fungiert damit als Membran, die auf von außen wirkende Drücke insoweit anspricht, als sie sich mehr oder weniger durchbiegt. Diese Durchbiegung kann mit Hilfe von für mechanische Spannungen empfindliche elektrische bzw. elektronische Bauelemente detektiert und entsprechend ausgewertet werden.

Zur Herstellung von Drucksensoren der zuvor beschriebenen Art sind Verfahren bekannt, bei denen die Ausbildung der Membran durch Verdünnen einer der beiden Halbleitersubstrate nach deren Verbondung mittels Schleifens erfolgt. Dem Schritt des Verdünnens durch Schleifen sind insoweit Grenzen hinsichtlich der minimal erzielbaren Membraridicken gesetzt, als das Halbleitersubstrat im Zuge seiner Verdünnung mehr und mehr die Tendenz hat, sich in Folge des beim Schleifen wirkenden Drucks in seinem den Hohlraum überspannenden Bereich in den Hohlraum hinein zu verformen. Damit weist dieser Bereich des Halbleitersubrates nach dem Schleifvorgang eine Dicke auf, die größer als die gewünschte Dicke und insbesondere größer als die Dicke des restlichen die Membranschicht bildenden Halbleitersubstrats ist.

In dem Artikel von CHANG-HAN YUN ET AL: "Fabrication of Silicon and Oxide Membranes Over Cavities Using Ion-Cut Layer Transfer", JOURNAL OF MICROELECTROMECHANICAL SYSTEMS, IEEE SERVICE CENTER, US, Bd. 9, Nr. 4, 1. Dezember 2000 (2000-12-01), XP011034603, ISSN: 1057-7157 und in US-A-2010/0171153 wird beschrieben, die dünne Membran über der Vertiefung eines (ersten) Halbleitersubstrats dadurch herzustellen, dass die mit diesem Halbleitersubstrat verbondete Grenzschicht des die (spätere) Membran aufweisenden (zweiten) Halbleitersubstrats, mittels des sogenannten SMARTCUT^{®}-Verfahrens abgetrennt wird.

Druckempfindliche Sensoren in Form von Transistoren sind in den beiden nachfolgend genannten Artikeln beschrieben:
JACHOWICZ R ET AL: "FET pressure sensor and iterative method for modelling of the device", 1. April 2002 (2002-04-01), SENSORS AND ACTUATORS A, ELSEVIER SEQUOIA S.A., LAUSANNE, CH, PAGE(S) 369 - 378, XP004361624, ISSN: 0924-4247
SVENSSON L ET AL: "Surface micromachining technology applied to the fabrication of a FET pressure sensor", JOURNAL OF MICROMECHANICS & MICROENGINEERING, INSTITUTE OF PHYSICS PUBLISHING, BRISTOL, GB, Bd. 6, Nr. 1, 1. März 1996 (1996-03-01), Seiten 80-83, XP020069032, ISSN: 0960-1317, DOI: 10.1088/0960-1317/6/1/018.

Diese beiden Artikel offenbaren ein Verfahren und eine Struktur eines FET-Transistors mit einem vergrabenen Hohlraum. Die bewegliche Membrane besteht aus SiO2 und wird nicht durch Verbonden auf einen Halbleiter hergestellt, sondern durch Abscheidung.

Der Artikel CHANG-HAN YUN ET AL: "Fabrication of Silicon and Oxide Membranes Over Cavities Using Ion-Cut Layer Transfer", Journal of Microelectromechanical Systems, IEEE Service Center, US, Bd. 9, Nr. 4, 1. Dezember 2000 (2000-12-01) XP011034603, ISSN: 1057-7157, und US-A-2010/171153 offenbaren die Herstellung einer Sensormembrane durch Bonden zweier Substrate und Spalten des oberen Substrats. Die Membrane dient jedoch nicht der Herstellung eines Transistors.

Aufgabe der Erfindung ist es, ein insoweit verbessertes Verfahren zur Herstellung eines Transistors mit vergrabenem Hohlraum zu schaffen, als die Membranschicht reproduzierbar relativ dünn ausgebildet und der Transistor in verschiedenen Beschaltungen zu unterschiedlichen Zwecken verwendet werden kann.

Zur Lösung dieser Aufgabe wird mit der Erfindung ein Verfahren zur Herstellung einer Halbleiterstruktur mit vergrabenem Hohlraum geschaffen, das die Schritte des Anspruchs 1 umfasst. Einzelne Ausgestaltungen des Verfahrens sind Gegenstand der Unteransprüche. Ferner schafft die Erfindung einen nach dem erfindungsgemäßen Verfahren erhältlichen Transistor.

Erfindungsgemäß wird also die Dicke der Membranschicht durch ein SMARTCUT^{®}-Verfahren eines der Halbleitersubstrate bestimmt. Dieses Halbleitersubstrat kann neben seiner Funktion als Membranschicht ggf. auch den vergrabenen Hohlraum in Form der Vertiefung aufweisen, die dann durch das andere Halbleitersubstrat überdeckt wird. Zweckmäßig ist es allerdings, wenn die Oberflächenvertiefung in demjenigen Halbleitersubstrat ausgebildet wird, das dem SMARTCUT^{®}-Verfahren nicht unterzogen wird.

Das SMARTCUT^{®}-Verfahren umfasst das Einbringen von Ionen mittels Implantation dicht unterhalb der Oberfläche eines Halbleitersubstrates, wodurch die in Höhe des Einschusses der Ionen angeordnete Kristallgitterebene des Halbleitersubstrats gestört und damit geschwächt wird. Bei einer anschließenden Erwärmung des so vorbehandelten Halbleitersubstrats entstehen "Risskeime" und schließlich ein makroskopischer Riss parallel zur Oberfläche bzw. Oberseite des Halbleitersubstrates. Dadurch kann eine lediglich wenige Kristallgitterebenen umfassende Halbleiterschicht (im Extremfall eine Einkristall-Halbleiterschicht) "abgesprengt" werden.

Gemäß einer alternativen Ausgestaltung der Erfindung wird ein Verfahren zur Herstellung eines MOS-Transistors mit einer einen vergrabenen Hohlraum aufweisenden Gate-Strukturvorgeschlagen, bei dem
a) ein erstes Halbleitersubstrat mit einer Oberseite bereitgestellt wird,
b) in der Oberseite des ersten Halbleitersubstrats eine Vertiefung ausgebildet wird,
c) ein zweites Halbleitersubstrat mit Kristallgitterebenen und einer Oberseite bereit gestellt wird, die sich im Wesentlichen parallel zu den Kristallgitterebenen erstreckt,
d) eine der Kristallgitterebenen, die sich in einem gewünschten Abstand von der Oberfläche des zweiten Halbleitersubstrats befindet, zur Erzeugung einer Sollbruchebene mittels Ionenimplantation geschwächt wird (SMARTCUT^{®}-Verfahren),
e) das zweite Halbleitersubstrat entlang der Sollbruchebene zur Erzeugung einer die Oberseite des zweiten Halbleitersubstrats aufweisenden Membranschicht gespalten wird (SMARTCUT^{®}-Verfahren) und
f) die Membranschicht des zweiten Halbleitersubstrats mit ihrer Oberseite mit der Oberseite des ersten Halbleitersubstrats unter Vakuumbedingungen verbondet (d. h. schmelzkontaktiert) wird, wobei die Membranschicht zur Bildung eines vergrabenen Hohlraums die Vertiefung in der Oberseite in dem ersten Halbleitersubstrat überdeckt,
wobei
- die Halbleiterstruktur aus dem mit der Membranschicht verbondeten ersten Halbleitersubstrat der Herstellung des MOS-Transistors dient,
- der vergrabene Hohlraum ein Gate-Dielektrikum bildet und
- in dem ersten Halbleitersubstrat unterhalb des vergrabenen Hohlraums ein Kanalgeblet sowie zumindestens an zwei Seiten des vergrabenen Hohlraums an diesen angrenzend ein Drain- und ein Source-Gebiet des MOS-Transistors und oberhalb des vergrabenen Hohlraums in der Membranschicht eine Gate-Elektrode ausgebildet sind.

Auch bei dieser alternativen Ausgestaltung gilt, dass die Vertiefung entweder in dem ersten Halbleitersubstrat, das dem SMARTCUT^{®}-Verfahren nicht unterzogen wird, oder in dem zweiten Halbleitersubstrat ausgebildet sein kann, das dem SMARTCUT^{®}-Verfahren unterzogen wird. Die Tiefe, in der die Ionen in das zweite Halbleitersubstrat eingeschossen werden, wenn dieses die Vertiefung aufweist, ist derart bemessen, dass dann die Dicke der Membranschicht im Bereich der Vertiefung gleich der gewünschten Membrandicke ist.

Mit Vorteil lassen sich das erfindungsgemäße Verfahren und die erfindungsgemäß hergestellte Halbleiterstruktur zur Herstellung eines (Absolut- oder Relativ-)Drucksensors oder zur Herstellung eines druckempfindlichen MOS-Transistors verwenden. Bei Verwendung für die Herstellung eines Drucksensors ist vorgesehen, dass in der Membranschicht mindestens ein gegenüber mechanischen Spannungen empfindliches elektrisches bzw. elektronisches Bauteil insbesondere mehrere zu einer Wheatstone-Brücke verschaltete elektrische bzw. elektronische Bauteile ausgebildet wird/werden. Im Falle eines Absolut-Drucksensors ist der vergrabene Hohlraum gegenüber der Umgebung verschlossen, während im Falle eines Relativ-Drucksensors in dem ersten oder dem zweiten Halbleitersubstrat ein in den vergrabenen Hohlraum führender Kanal ausgebildet wird.

Bei Verwendung der erfindungsgemäß hergestellten Halbleiterstruktur zur Herstellung eines druckempfindlichen MOS-Transistors dient der vergrabene Hohlraum als Gate-Dielektrikum, wobei in dem ersten Halbleitersubstrat unterhalb des vergrabenen Hohlraums ein Kanalgebiet sowie zumindest zu zwei Seiten des vergrabenen Hohlraums an diesen angrenzend ein Drain- und ein Source-Gebiet des Transistors ausgebildet sind, während sich oberhalb des vergrabenen Hohlraums in oder auf der Membranschicht eine Gate-Elektrode befindet.

In vorteilhafter Weiterbildung der Erfindung kann vorgesehen sein, dass der MOS-Transistor in einer elektrischen Schaltung als JFET ausgeführt ist. Alternativ kann der MOS-Transistor in einer elektrischen Schaltung auch als Kondensator verwendet werden. Die Elektroden werden dann von dem Substrat und dem Gate bzw. der Gate-Elektrode gebildet. Die Drain- und Source-Anschlussgebiete sind dann inaktiv bzw. können im Bedarfsfalle inaktiv geschaltet werden.

In weiterer vorteilhafter Ausgestaltung der Erfindung kann vorgesehen sein, dass der vergrabene Hohlraum als Kanal, insbesondere als mikrofluidischer Kanal benutzt wird, der von einem gasförmigen oder flüssigen Medium durchströmt wird. Je nach Applikation kann nun durch Auswertung von Transistorparametern das Medium bestimmt werden, das sich in dem Kanal befindet. Das Medium beeinflusst nämlich das Gate-Dielektrikum, was schließlich zur Bestimmung des Mediums ausgenutzt wird. Ebenso ist es möglich, bei bekanntem Medium dessen Temperatur und/oder Druck zu bestimmen, sofern sich diese Parameter auf eine Veränderung der Transistorparameter auswirken. Somit lassen sich also durch Auswertung der Transistorparameter Rückschlüsse auf verschiedene physikalische Eigenschaften des den Kanal durchströmenden Mediums, wie beispielsweise dessen Zusammensetzung und beispielsweise Druck und Temperatur ziehen.

In weiterer vorteilhafter Ausgestaltung der Erfindung kann vorgesehen sein, dass die Halbleiterstruktur aus dem mit der Membranschicht verbondeten ersten Halbleitersubstrat der Herstellung eines mikroelektromechanischen Drucksensors dient, wobei in der Membranschicht mindestens ein gegenüber mechanischen Spannungen empfindliches elektrisches oder elektronisches Bauteil ausgebildet wird und insbesondere mehrere zu einer Wheatstone-Brücke verschaltete, gegenüber mechanischen Spannungen empfindliche elektrische oder elektronische Bauteile ausgebildet werden. Hierbei kann ferner noch vorgesehen sein, dass in dem ersten Halbleitersubstrat ein in den vergrabenen Hohlraum führender Kanal ausgebildet wird.

Die Erfindung wird nachfolgend unter Bezugnahme auf die Zeichnungen näher erläutert.

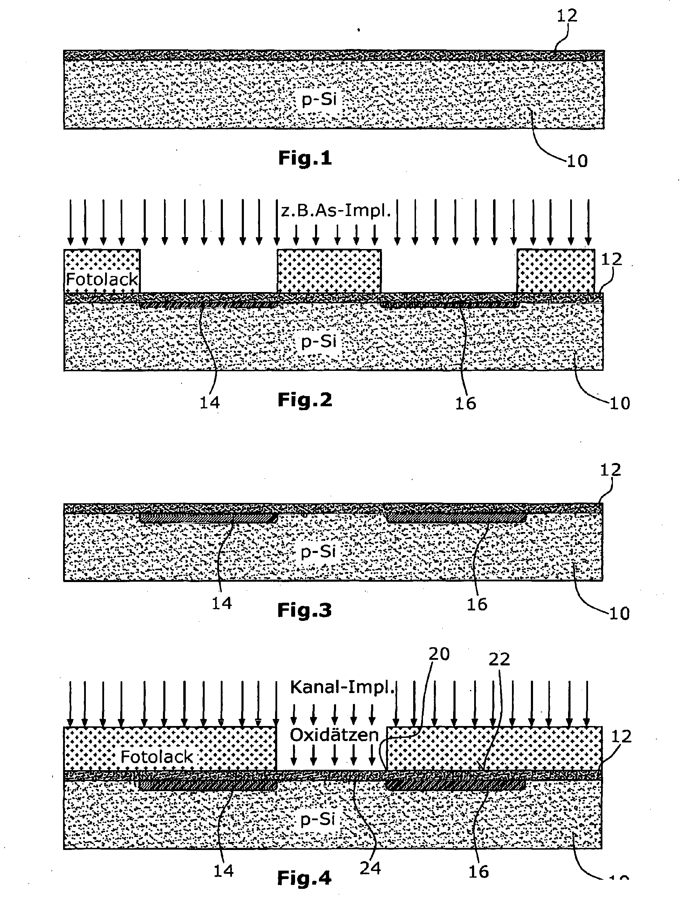

In den Fign. 1 bis 17 sind die einzelnen Herstellungsschritte eines druckabhängigen Transistors dargestellt, dessen Leitfähigkeit sich in Abhängigkeit vom Druck, dem der Transistor ausgesetzt ist, verändert.
Fig. 1 zeigt ein erstes Halbleitersubstrat 10, bei dem es sich in diesem Ausführungsbeispiel um p-dotiertes Silizium handelt. Die Oberseite des Hableitersubstrats 10 wird nach einer chemischen Reinigung des Wafer und einer thermischen Oxidation durch eine obere SiO2-Schicht 12 gebildet.
Fig. 2 zeigt die Verfahrensschritte zur Herstellung von Source- und Drain- Gebieten 14,16 (siehe Fig. 3) eines druckabhängigen MOS-Transistors 18 (siehe Fig. 17). Zu diesem Zweck werden zunächst n-dotierte Gebiete nahe der Oberfläche des ersten Halbleitersubstrates 10 durch eine Ionenimplantation mit vorgeschaltetem Fotolithografieverfahren implantiert (siehe Fig. 2). Danach erfolgt nach Entfernung der Fotolackmaske, die für die Ionenimplantation erforderlich war, eine chemische Reinigung und eine thermische Ausdiffusion der Source- und Drain-Gebiete 14,16.

In Fig. 4 ist der Prozessschritt der Herstellung einer Oberflächenvertiefung 20 an der Oberseite 22 des ersten Halbleitersubstrates 10 und der Einbringung einer Kanalimplantation zur Erzeugung des Kanalgebietes 24 gezeigt.

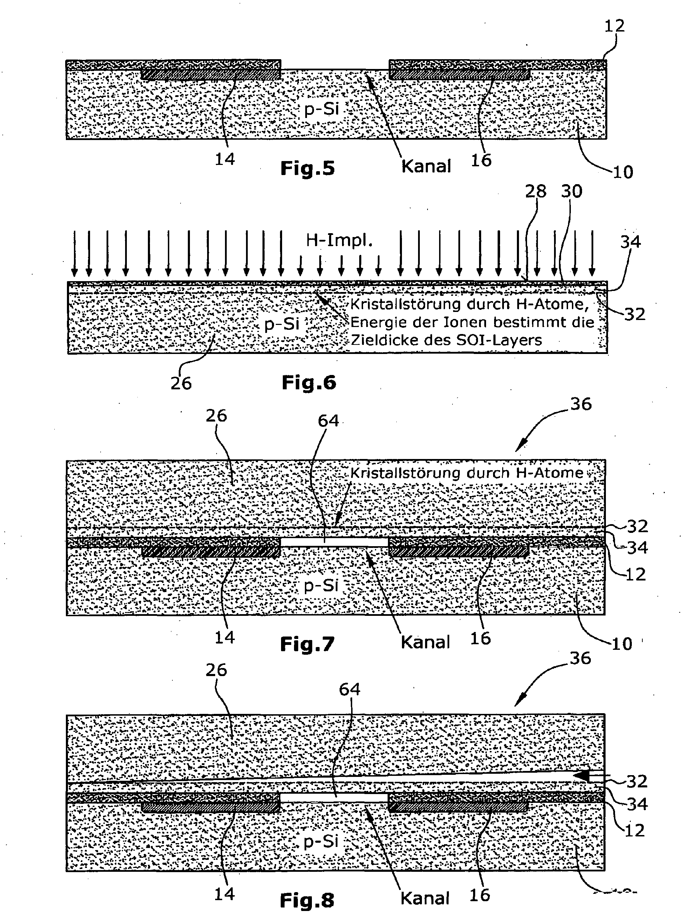

Nach Entfernung der Fotolackmaske sowie nach dem chemischen Reinigen und nach dem thermischen Ausdiffundieren ergibt sich die Situation gemäß Fig. 5.

An dieser Stelle sei angemerkt, dass für die Herstellung eines vergrabenen Hohlraums, was Gegenstand der Erfindung ist, die zuvor genannten Dotierungsgebiete nicht zwingend erforderlich sind. Diese Ionenimplantationsgebiete dienen vielmehr ausschließlich der Anwendung der erfindungsgemäßen Technologie zur Herstellung vergrabener Hohlräume im Zusammenhang mit druckempfindlichen Transistoren.

In Fig. 6 ist ein zweites Halbleitersubstrat (Top-Wafer) 26 mit einer Oberseite 28 gezeigt, die ebenfalls durch eine thermische Oxidation entstanden und demzufolge von einer dünnen S102-Schicht 30 gebildet ist. Die Oberseite 28 befindet sich in einer Ebene, die parallel zu den Kristallgitterebenen des zweiten Halbleitersubstrats 26 verläuft. Auch beim zweiten Halbleitersubstrat 26 handelt es sich in diesem Ausführungsbeispiel um p-dotiertes Silizium.

Wie in Fig. 6 gezeigt, ist die bei 32 angedeutete Kristallgitterebene gestört, was gemäß der SMARTCUT^{®}-Technologie durch die Implantation von Wasserstoffionen erfolgt. Hierdurch entsteht eine obere dünne Schicht 34 aus Material des zweiten Halbleitersubstrats sowie der SiO2-Schicht 30. Diese Schicht 34 ist die spätere Membranschicht, was weiter unten noch erläutert werden wird.

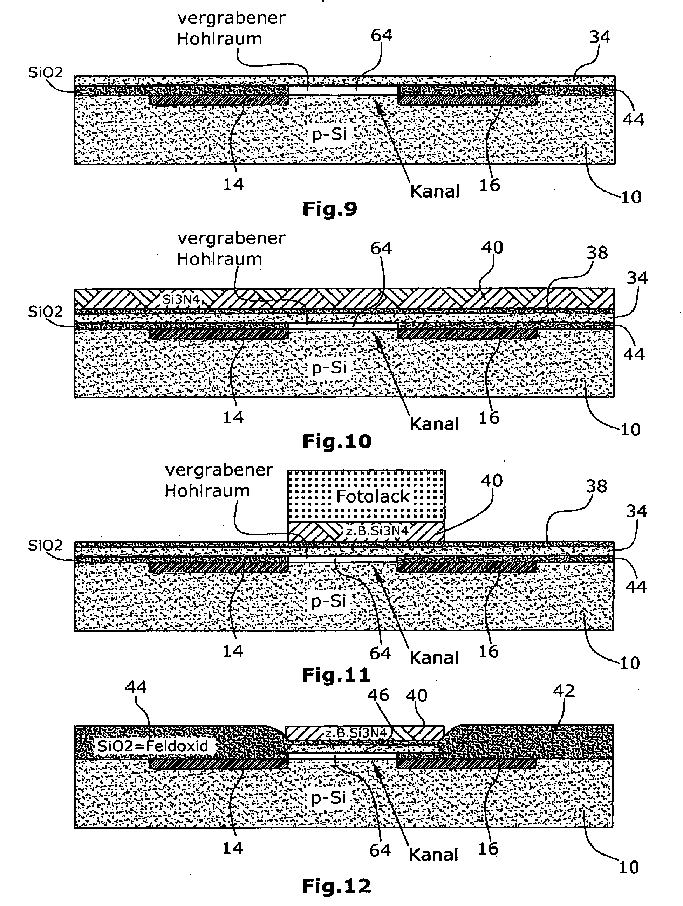

Die beiden gemäß der vorherigen Beschreibung vorbereiteten Halbleitersubstrate 10,26 werden nun mit ihren beiden Oberseiten 22,28 miteinander verbondet, das heißt schmelzkontaktiert. Diesbezüglich ist es von Vorteil, dass die beiden Halbleitersubstrat-Oberseiten 22,28 durch Siliziumoxid gebildet sind. Die verbondete Halbleiterstruktur 36 ist in Fig. 7 gezeigt. Durch eine anschließende thermische Behandlung werden in der gestörten Kristallgitterebene 32 Risskeime induziert, die schließlich zu einem Riss in dem zweiten Halbleitersubstrat 26 längst der Kristallgitterebene führen (siehe Fig. 8), so dass die Schicht 34 des Halbleitersubstrats 26 mit dem Halbleitersubstrat 10 verbondet bleibt. Danach ergibt sich die Situation gemäß Fig. 9.

Die weiteren Prozessschritte gemäß den Fign. 10 bis 17 dienen der Herstellung des druckabhängigen Transistors 18. Zunächst werden gemäß Fig. 10 auf der Membranschicht 34 eine Siliziumoxid-Schicht 38 mit einer darauf befindlichen Nitridschicht 40 gebildet. Die Nitridschicht 40 wird anschließend strukturiert (siehe Fig. 11), so dass sich diese Nitridschicht 40 lediglich noch im Bereich des späteren Transistor-Gates befindet.

Gemäß Fig. 12 erfolgt nach einer Entfernung der für die Strukturierung der Nitridschicht 40 erforderlichen Fotolackschicht und nach einer chemischen Reinigung eine lokale Oxidation beidseitig der verbleibenden strukturierten Nitridschicht 40 und durch die Membranschicht 34 hindurch, so dass dicke Feldoxidbereiche 42,44 entstehen, die untereinander durch die dünne Siliziumoxid-Schicht 38 unterhalb der Nitridschicht 40 bzw. der Nitridschichtinsel verbunden sind. Es stellt sich die Situation gemäß Fig. 12 ein.

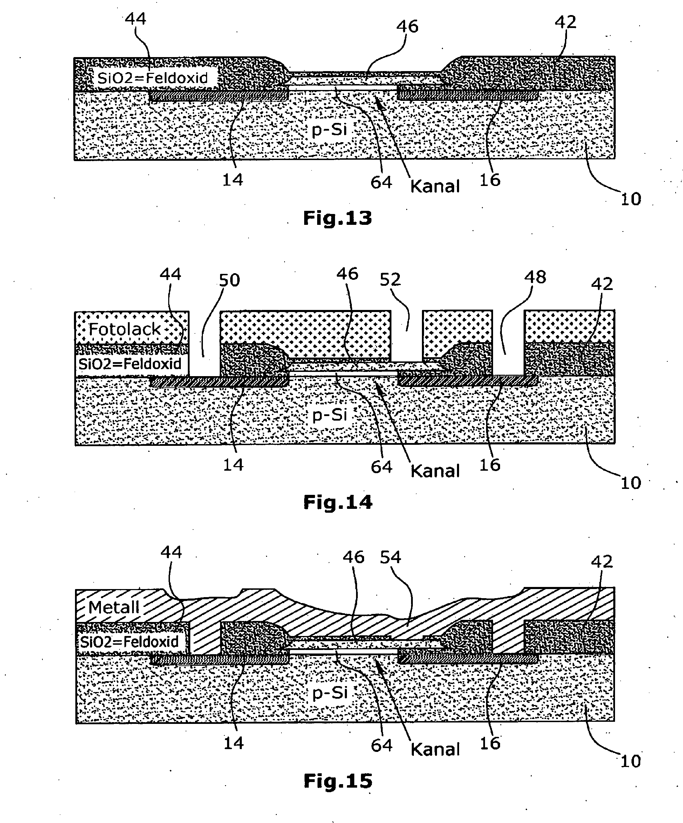

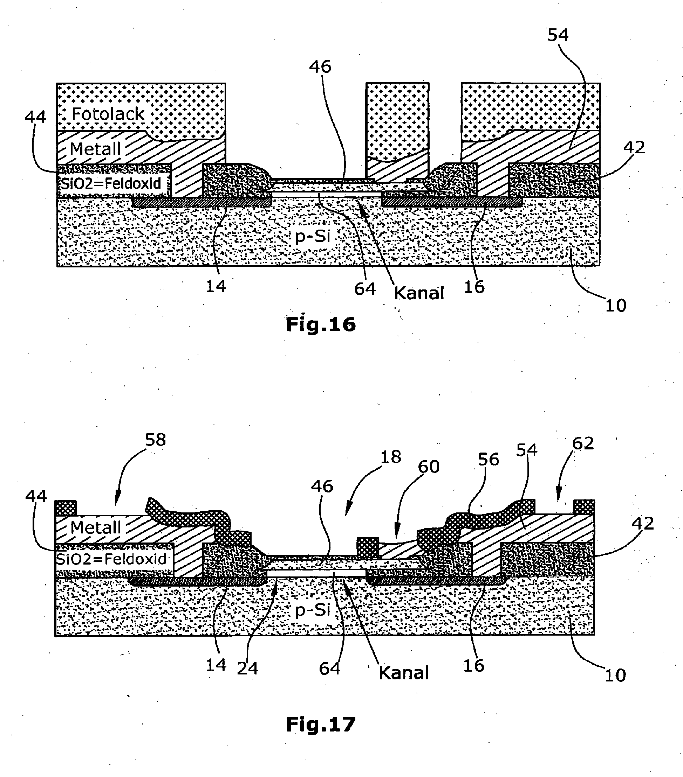

Anschließend wird, wie in Fig. 13 gezeigt, die verbliebene Insel der Nitridschicht 40 entfernt und mittels Fotolithografie und Oxidätzung die Kontaktierungslöcher zur Kontaktierung der Source- und Drain-Gebiete 14, 16 sowie der Gate-Elektrode 46 durchgeführt. Dies ist in Fig. 14 gezeigt. Die Gate-Elektrode 46 wird dabei von demjenigen Bereich der früheren Membranschicht 34 gebildet, der sich zwischen den beiden Feldoxidbereichen 42,44 befindet. In die Kontaktierungslöcher 48,50,52 wird anschließend (siehe Fig. 15) elektrisch leitendes Material 54 durch beispielsweise eine Metallisierung der Oberfläche eingebracht. Die Metallisierung bzw. das elektrisch leitende Material 54 wird anschließend strukturiert, und zwar unter Verwendung von Lithografie-Schritten (siehe Fig. 16), um sodann durch eine Passivierungsschicht 56 passiviert zu werden. In der Passivierungsschicht 56 werden dann die Bondpadöffnungen 58,60,62 freigelegt. Damit ist der druckabhängige Transistor 18 grundsätzlich fertiggestellt (siehe Fig. 17). Unterhalb der Gate-Elektrode 46 befindet sich die ehemals in der Oberseite 22 des ersten Halbleitersubstrats 10 ausgebildete Vertiefung 20, die durch die Gate-Elektrode 47 nun als vergrabener Hohlraum 64 ausgebildet ist (siehe auch die Fign. 7 bis 16, wobei der vergrabene Hohlraum 64 bereits in dem Herstellungsschritt gemäß Fig. 7 ausgebildet ist). Der unter der Gate-Elektrode 46 gelegene Hohlraum 64 übernimmt die Funktion des Gate-Dielektrikums des Transistors 18. In Abhängigkeit von dem außen anstehenden Druck biegt sich die den vergrabenen Hohlraum 64 überspannende Gate-Elektrode 47 durch, wodurch sich die kapazitive Kopplung der Gate-Elektrode 47 zum Kanalgebiet 24 und damit wiederum die Leitfähigkeit des Transistors 18 ändert.

Es sei an dieser Stelle nochmals hervorgehoben, dass für das eigentliche erfindungsgemäße Verfahren der Herstellung eines vergrabenen Hohlraums die Verfahrensschritte bis einschließlich Fig. 8 ausreichend sind, wobei, wie bereits oben erwähnt, auch die implantierten Source- und Drain-Gebiete 14, 16 nicht zwingend erforderlich sind, um den vergrabene Hohlraum 64 in der Halbleiterstruktur 36 zu erzeugen.

### BEZUGSZEICHENLISTE

- 10: Halbleitersubstrat,
- 12: Siliziumoxid-Schicht
- 14: Drain-Gebiet
- 16: Drain-Gebiet
- 18: MOS-Transistor
- 20: Oberflächenvertiefung, Vertiefung
- 22: Halbleitersubstrat-Oberseite
- 24: Kanalgebiet
- 26: Halbleitersubstrat
- 28: Halbleitersubstrat-Oberseite
- 30: SiO2-Schicht
- 32: Kristallgitterebene
- 34: Membranschicht
- 36: Halbleiterstruktur
- 38: Siliziumoxid-Schicht
- 40: Siliziumnitrid-Schicht
- 42: Feldoxid
- 44: Feldoxid
- 46: Gate-Elektrode, Bereich der Membranschicht zwischen Feldoxidbereichen
- 48: Kontaktierungslocher
- 50: Kontaktierungslocher
- 52: Kontaktierungslocher
- 54: Material
- 56: Passivierungsschicht
- 58: Bondpadöffnung
- 60: Bondpadöffnung
- 62: Bondpadöffnung
- 64: Hohlraum

## Patentansprüche

1. Verfahren zur Herstellung eines MOS-Transistors mit einer einen vergrabenen Hohlraum aufweisenden Gate-Struktur, wobei bei dem Verfahren
a) ein erstes Halbleitersubstrat (10) mit einer Oberseite (22) bereitgestellt wird,
b) in der Oberseite (22) des ersten Halbleitersubstrats (10) eine Vertiefung ausgebildet wird,
c) ein zweites Halbleitersubstrat (26) mit Kristallgitterebenen und einer Oberseite (28) bereit gestellt wird, die sich im Wesentlichen parallel zu den Kristaligitterebenen erstreckt,
d) eine der Kristallgitterebenen, die sich in einem gewünschten Abstand von der Oberseite (28) des zweiten Halbleitersubstrats (26) befindet, zur Erzeugung einer Sollbruchebene mittels Ionenimplantation geschwächt wird,
e) das zweite Halbleitersubstrat (26) mit seiner Oberseite (28) auf der Oberseite (22) des ersten Halbleitersubstrats (10) unter Vakuumbedingungen verbondet wird, wobei das zweite Halbleitersubstrat (26) zur Bildung eines vergrabenen Hohlraums (60) die Vertiefung (20) in der Oberseite (22) des ersten Halbleitersubstrat (10) überdeckt, und
f) das zweite Halbleitersubstrat (26) entlang der Sollbruchebene zum Verbleib einer Membranschicht (34) auf der Oberseite (22) des ersten Halbleitersubstrats (10) gespalten wird,
wobei
- die Halbleiterstruktur (36) aus dem mit der Membranschicht (34) verbondeten ersten Halbleitersubstrat (10) der Herstellung des MOS-Transistors (18) dient,
- der vergrabene Hohlraum (64) ein Gate-Dielektrikum bildet und
- in dem ersten Halbleitersubstrat (10) unterhalb des vergrabenen Hohlraums (64) ein Kanalgebiet sowie zumindestens an zwei Seiten des vergrabenen Hohlraums (64) an diesen angrenzend ein Drainund ein Source-Gebiet (14,16) des MOS-Transistors (18) und oberhalb des vergrabenen Hohlraums (64) in der Membranschicht (34) eine Gate-Elektrode (46) ausgebildet sind.

2. Verfahren nach Anspruch 1, **dadurch gekennzeichnet, dass** der Schritt f) vor dem Schritt e) ausgeführt wird, indem das bereitgestellte zweite Halbleitersubstrat (26) entlang der Sollbruchebene zur Erzeugung einer die Oberseite (28) des zweiten Halbleitersubstrats (26) aufweisenden Membranschicht gespalten wird und die Membranschicht (34) des zweiten Halbleitersubstrats (26) mit ihrer Oberseite mit der Oberseite des ersten Halbleitersubstrats (10) unter Vakuumbedingungen verbondet wird, wobei die Membranschicht (34) zur Bildung eines vergrabenen Hohlraums (64) die Vertiefung (20) in der Oberseite (22) des ersten Halbleitersubstrats (10) überdeckt.

3. Verfahren nach Anspruch 1 oder 2, **dadurch gekennzeichnet, dass** der MOS-Transistor (18) in einer elektrischen Schaltung als JFET ausgeführt wird.

4. Verfahren nach Anspruch 1 oder 2, **dadurch gekennzeichnet, dass** der MOS-Transistor (18) in einer elektrischen Schaltung als Kondensator mit dem ersten Halbleitersubstrat (10) und der Gate-Elektrode (46) als dessen beide Elektroden verwendet wird.

5. Verfahren nach Anspruch 1 oder 2, **dadurch gekennzeichnet, dass** der vergrabene Hohlraum (64) als Kanal, insbesondere als mikrofluidischer Kanal benutzt wird, der von einem gasförmigen oder flüssigen Medium durchströmt wird.

6. MOS-Transistor mit einer Gate-Struktur, die einen vergrabenen Hohlraum aufweist, erhältlich nach einem Verfahren gemäß einem der vorhergehenden Ansprüche.

## Claims

1. Method for producing an MOS transistor comprising a gate structure including a buried cavity, wherein, in said method,
a) a first semiconductor substrate (10) having a top side (22) is provided,
b) a recess is formed in the top side (22) of the first semiconductor substrate (10),
c) a second semiconductor substrate (26) having crystal lattice planes and a top side (28) is provided, said top side (28) extending substantially parallel to the crystal lattice planes,
d) one of the crystal lattice planes that is arranged at a desired distance from the top side (28) of the second semiconductor substrate (26), is weakened by ion implantation for generating a predetermined weakening plane,
e) the second semiconductor substrate (26) is by its top side (28) bonded under vacuum conditions to the top side (22) of the first semiconductor substrate (10), wherein, for forming a buried cavity (60), the second semiconductor substrate (26) is made to cover the recess (20) in the top side (22) of the first semiconductor substrate (10), and
f) the second semiconductor substrate (26) is split along the predetermined weakening plane for leaving a membrane layer (34) on the top side (22) of the first semiconductor substrate (10),
wherein
- the semiconductor structure (36) from the first semiconductor substrate (10) bonded to the membrane layer (34) serves for generating the MOS transistor (18),
- the buried cavity (64) forms a gate dielectric, and
- in the first semiconductor substrate (10) below the buried cavity (64), a channel region is formed and, adjacent to the buried cavity (64) at on least two sides thereof, a drain and a source region (14,16) of the MOS transistor (18) are formed and, above the buried cavity (64), a gate electrode (46) is formed in the membrane layer (34).

2. The method according to claim 1, **characterized in that** step f) is performed prior to step e) **in that** the second semiconductor substrate (26) which has been provided is split along the predetermined breaking plane for generating a membrane layer comprising the top side (28) of the second semiconductor substrate (26) and **in that** the membrane layer (34) of the second semiconductor substrate (26) is bonded by its top side to the top side of the first semiconductor substrate (10) under vacuum conditions, wherein the membrane layer (34) covers the recess (20) in the top side (22) of the first semiconductor substrate (10) for forming a buried cavity (64).

3. The method according to claim 1 or 2, **characterized in that** the MOS transistor (18) is formed in an electric circuit as a JFET.

4. The method according to claim 1 or 2, **characterized in that** the MOS transistor (18) is formed in an electric circuit as a capacitor, with the first semiconductor substrate (10) and the gate electrode (46) forming the two electrodes of the capacitor.

5. The method according to claim 1 or 2, **characterized in that** the buried cavity (64) is used as a channel, particularly as a microfluidic channel having a gaseous of liquid medium flowing therethrough.

6. MOS transistor comprising a gate structure including a buried cavity, generated by a method according to any one of the preceding claims.

## Revendications

1. Procédé de fabrication d'un transistor MOS avec une structure de grille comportant un espace vide enterré, au cours de ce procédé
a) un premier substrat semi-conducteur (10) avec une face supérieure (22) étant mis à disposition,
b) sur la face supérieure (22) du premier substrat semi-conducteur (10), un enfoncement étant formé,
c) un second substrat semi-conducteur (26) avec des plans de réseau cristallin et une face supérieure (28) qui s'étend essentiellement parallèlement aux plans de réseau cristallin, étant mis à disposition,
d) un des plans de réseau cristallin situé à une distance souhaitée de la face supérieure (28) du second substrat semi-conducteur (26) étant affaibli par implantation d'ions pour réaliser un plan de fracture prédéterminé,
e) le second substrat semi-conducteur (26) étant bondé avec sa face supérieure (28) sur la face supérieure (22) du premier substrat semi-conducteur (10) sous conditions de vide, le second substrat semi-conducteur (26) recouvrant l'enfoncement (20) sur la face supérieure (22) du premier substrat semi-conducteur (10) pour la formation d'un espace vide (60) enterré, et
f) le second substrat semi-conducteur (26) étant fendu le long du plan de fracture prédéterminé pour laisser subsister une couche de membrane (34) sur la face supérieure (22) du premier substrat semi-conducteur (10),
où
- la structure semi-conductrice (36) formée du premier substrat semi-conducteur (10) pourvu de la couche de membrane (34) par bondage sert à la fabrication du transistor MOS (18),
- l'espace vide enterré (64) forme un diélectrique de grille et
- dans le premier substrat semi-conducteur (10), en-dessous de l'espace vide enterré (64), une zone de canal et, au moins sur deux côtés de l'espace vide enterré (64), une zone de drain et une zone de source (14, 16) du transistor MOS (18) et, au-dessus de l'espace vide enterré (64), une électrode de grille (46) sont formés.

2. Procédé selon la revendication 1, **caractérisé en ce que** l'étape f) est effectuée avant l'étape e) en fendant le second substrat semi-conducteur (26) mis à disposition, le long du plan de fracture prédéterminé pour la réalisation d'une couche de membrane pourvue de la face supérieure (28) du second substrat semi-conducteur (26) et que la couche de membrane (34) du second substrat semi-conducteur (26) est bondée avec sa face supérieure avec la face supérieure du premier substrat semi-conducteur (10) sous conditions de vide, la couche de membrane (34) recouvrant l'enfoncement (20) sur la face supérieure (22) du premier substrat semi-conducteur (10) pour la formation d'un espace vide (64) enterré.

3. Procédé selon la revendication 1 ou 2, **caractérisé en ce que** le transistor MOS (18) est réalisé dans un circuit électrique comme JFET.

4. Procédé selon la revendication 1 ou 2, **caractérisé en ce que** le transistor MOS (18) est utilisé dans un circuit électrique comme condensateur avec le premier substrat semi-conducteur (10) et l'électrode de grille (46) comme ses deux électrodes.

5. Procédé selon la revendication 1 ou 2, **caractérisé en ce que** l'espace vide enterré (64) est utilisé comme canal microfluidique traversé par un fluide sous forme de gaz ou liquide.

6. Transistor MOS avec une structure de grille comportant un espace vide enterré, réalisable selon un procédé selon l'une des revendications précédentes.
